(19)

Europäisches
Patentamt
European
Patent Office
Office européen
des brevets

(11) **EP 2 833 551 A1**

(12) **EUROPEAN PATENT APPLICATION**

(43) Date of publication:
04.02.2015 Bulletin 2015/06

(51) Int Cl.:
*H03K 17/955* (2006.01)   *H03K 17/96* (2006.01)
*G06F 3/044* (2006.01)

(21) Application number: 14179265.5

(22) Date of filing: 31.07.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 01.08.2013 JP 2013160051

(71) Applicant: **AISIN SEIKI KABUSHIKI KAISHA**
**Kariya-shi, Aichi-ken 448-8650 (JP)**

(72) Inventor: **Sugiura, Takehiko**
**KARIYA-SHI, AICHI-KEN, 448-8650 (JP)**

(74) Representative: **Intès, Didier Gérard André et al**
**Cabinet Beau de Loménie**
**158, rue de l'Université**
**75340 Paris Cedex 07 (FR)**

(54) **CAPACITANCE SENSOR**

(57)    A capacitance sensor (100, 600, 800) includes: a transmitting electrode (120, 620a to 620i); a receiving electrode (130, 630); and a switching unit (170, 670) that performs switching between a self-capacitance detection mode for measuring a change in self-capacitance of at least one of the transmitting electrode and the receiving electrode to detect an object to be detected (200) and a mutual capacitance detection mode for measuring a change in mutual capacitance between the transmitting electrode and the receiving electrode to detect an object to be detected.

*FIG.1*

EP 2 833 551 A1

## Description

TECHNICAL FIELD

This disclosure relates to a capacitance sensor.

BACKGROUND DISCUSSION

Hitherto, capacitance sensors that detect the position or operation of an object to be detected as a change in capacitance have been known. The capacitance sensor includes one or a plurality of electrodes for detection. The capacitance value of the electrode changes with the approach and movement of the object to be detected. The capacitance sensor can detect the operation of the object to be detected by measuring such a change in capacitance value as an electrical signal. In recent years, such a capacitance sensor has been used in a wide range of application such as a noncontact detection detecting device of an object, a touch panel for display and the like.

JP 7-29467A (Reference 1) discloses a capacitance sensor including a sensor unit having a detection electrode, an oscillation circuit that outputs a change in capacitance, and a detection circuit. A transmitting circuit is constituted by a capacitance Cd, a feedback resistor R, a buffer circuit, and a Schmitt trigger inverter, and outputs a signal having a frequency determined by the time constant of the capacitance Cd and the feedback resistor R. When an object to be detected comes close to the detection electrode, the capacitance Cd between the detection electrode and the object to be detected changes, and the oscillation frequency of a signal which is output from the oscillation circuit changes. In this manner, it can be detected whether the object to be detected comes close to the detection electrode.

JP 2012-203901A (Reference 2) discloses a capacitance sensor which is used in a display including a touch sensor. The capacitance sensor includes a plurality of signal wirings Tx and a plurality of signal wirings Rx which intersect each other, a capacitance is formed between each of the signal wirings Tx and Rx. A voltage is applied between the signal wirings Tx and Rx, and thus an electric field is formed between the signal wirings Tx and Rx. When the electric field is blocked by the finger of an operator, charge accumulated between the signal wirings Tx and Rx is reduced. Such a change in charge is measured, and thus the approach of the finger, that is, the approach of the finger to a display is detected. In addition, since a large number of detection places are formed between the plurality of signal wirings Tx and signal wirings Rx, coordinate value data of a touch position can also be acquired.

In the capacitance sensor of a type in which a capacitance (hereinafter, referred to as a self-capacitance) is detected using a single electrode disclosed in Reference 1, it can be determined whether the object to be detected is located near the detection electrode. Specifically, the capacitance sensor of a type in which the self-capacitance is detected detects a change in capacitance between the electrode and the object to be detected, and thus it is possible to detect that the object to be detected is present. However, since an electric field is distributed extensively, it is difficult to specify the position of the object to be detected from the measured self-capacitance onto one point, and to accurately detect the position of the object to be detected. For example, it is not likely that a motion sensor or the like used for detecting the movement (motion) of the object to be detected which is located near the capacitance sensor may be applied to an application required to detect a change in position.

On the other hand, in the capacitance sensor of a type in which a capacitance (hereinafter, referred to as a mutual capacitance) between two types of electrodes disclosed in Reference 2 is detected, an electric field is concentrated in the vicinity of the electrodes and thus the sensitivity of position detection is satisfactory. Therefore, as in Reference 2, a plurality of detection places are provided and a detected place is specified, thereby allowing the position to be detected. Further, a change in the detected place is specified by performing measurement continuously repeatedly, and thus the capacitance sensor can also be applied to an application required to detect the movement of a motion sensor or the like. However, since the range of a measurable distance is narrow, it is difficult to detect, for example, an object to be detected which is located at a long distance.

From the above reason, either capacitance sensor of Reference 1 and Reference 2 has a problem for an application required to detect both the object to be detected which is located at a position distant from the capacitance sensor and the movement of the object to be detected which is located near the capacitance sensor. Therefore, as for such an application, the capacitance sensors of the related art as disclosed in Reference 1 and Reference 2 are not able to be used independently. When the capacitance sensors of both Reference 1 and Reference 2 are used simultaneously, a plurality of sensor elements and detection circuits are required, which leads to an increase in the size of the capacitance sensor. For this reason, the installation area thereof increases, and thus economic efficiency also deteriorates.

SUMMARY

Thus, a need exists for a capacitance sensor capable of performing both the detection of an object to be detected which is located at a position distant from a capacitance sensor and the detection of the movement of the object to be detected which is located near the capacitance sensor, using a single element.

An aspect of this disclosure is directed to a capacitance sensor including: a transmitting electrode; a receiving electrode; and a switching unit that performs switching between a self-capacitance detection mode for measuring a change in self-capacitance of at least one of the transmitting electrode and the receiving electrode to detect an object to be detected and a mutual capacitance detection mode for measuring a change in mutual capacitance between the transmitting electrode and the receiving electrode to detect an object to be detected.

In the capacitance sensor according to the aspect of this disclosure, it is possible to perform both the detection of an object to be detected which is located at a position distant from a capacitance sensor and the detection of the movement of the object to be detected which is located near the capacitance sensor, using a single element.

The capacitance sensor according to the aspect of this disclosure may be configured to further include a grounded capacitor which is electrically connected between the transmitting electrode or the receiving electrode and a ground.

The capacitance sensor according to the aspect of this disclosure may be configured such that the measurement of the self-capacitance and the mutual capacitance is performed by measuring a charging time of charge which is charged when a voltage is applied to at least one of the self-capacitor, the mutual capacitor, and the grounded capacitor.

The capacitance sensor according to the aspect of this disclosure may be configured such that a plurality of the transmitting electrodes or a plurality of the receiving electrodes are provided, and the capacitance sensor further comprises a plurality of switches which are respectively connected to the plurality of transmitting electrodes or the plurality of receiving electrodes.

The capacitance sensor according to the aspect of this disclosure may be configured such that, in the measurement in the mutual capacitance detection mode, the measurement of the mutual capacitance between each transmitting electrode and the receiving electrode is performed by closing the plurality of switches in order.

The capacitance sensor according to the aspect of this disclosure may be configured such that the transmitting electrode and the receiving electrode are arranged side by side on the same plane of the same base with an interelectrode gap interposed therebetween.

The capacitance sensor according to the aspect of this disclosure may be configured such that the receiving electrode is disposed so as to surround the transmitting electrode, or the transmitting electrode is disposed so as to surround the receiving electrode.

The capacitance sensor according to the aspect of this disclosure may be configured such that the transmitting electrode has a circular shape.

The capacitance sensor according to the aspect of this disclosure may be configured such that the interelectrode gap has an annular shape with a uniform width.

The capacitance sensor according to the aspect of this disclosure may be configured such that the switching unit performs switching to the mutual capacitance detection mode, using detection of the object to be detected coming close during detection based on the self-capacitance detection mode as a trigger.

The capacitance sensor according to the aspect of this disclosure may be configured such that the switching unit performs switching to the self-capacitance detection mode, using none-detection of movement of the object to be detected during detection based on the mutual capacitance detection mode as a trigger.

BRIEF DESCRIPTION OF THE DRAWINGS

The foregoing and additional features and characteristics of this disclosure will become more apparent from the following detailed description considered with the reference to the accompanying drawings, wherein:

Fig. 1 is a block diagram illustrating a capacitance sensor according to an embodiment disclosed here;
Fig. 2 is a schematic diagram illustrating a sensor element unit according to an embodiment disclosed here;
Fig. 3 is a cross-sectional view taken along line III-III of the sensor element unit according to the embodiment disclosed here;
Fig. 4 is a diagram illustrating an operation in a self-capacitance detection mode in the capacitance sensor according to the embodiment disclosed here;
Fig. 5 is a diagram illustrating an operation in a mutual capacitance detection mode in the capacitance sensor according to the embodiment disclosed here;
Fig. 6 is a diagram illustrating an example of a capacitance measurement circuit;
Fig. 7 is a diagram illustrating a temporal change in voltage which is applied from a voltage source;
Fig. 8 is a diagram illustrating a temporal change in voltage which is measured by a voltmeter;
Fig. 9 is an equivalent circuit diagram in a self-capacitance detection mode;
Fig. 10 is an equivalent circuit diagram in a mutual capacitance detection mode;
Fig. 11 is a schematic diagram illustrating an electric field distribution in a self-capacitance detection mode, in the cross-sectional view of Fig. 3;
Fig. 12 is a schematic diagram illustrating an electric field distribution in a self-capacitance detection mode in which an object to be detected comes close, in the cross-sectional view of Fig. 3;
Fig. 13 is a schematic diagram illustrating an electric field distribution in a mutual capacitance detection mode, in the cross-sectional view of Fig. 3;
Fig. 14 is a schematic diagram illustrating an electric field distribution in a mutual capacitance detection mode in which an object to be detected comes close, in the cross-sectional view of Fig. 3;
Fig. 15 is a perspective view of the sensor element unit illustrating an electric field distribution in a mutual capacitance detection mode;
Fig. 16 is a block diagram illustrating a capacitance sensor according to an embodiment disclosed here;

Fig. 17 is a schematic diagram illustrating a sensor element unit according to an embodiment disclosed here;

Fig. 18 is a cross-sectional view taken along line XVII-XVIII of the sensor element unit according to the embodiment disclosed here;

Fig. 19 is a flow diagram illustrating an algorithm relating to switching between a self-capacitance detection mode and a mutual capacitance detection mode;

Fig. 20 is a block diagram illustrating a capacitance sensor according to an embodiment disclosed here;

Fig. 21 is an operation diagram based on a second self-capacitance detection mode in the capacitance sensor according to the embodiment disclosed here; and

Fig. 22 is a block diagram illustrating an example in which a reset circuit is configured using a transistor.

DETAILED DESCRIPTION

Hereinafter, embodiments disclosed here will be described with reference to the accompanying drawings. Meanwhile, this disclosure is not limited to the embodiments, and can be appropriately modified without departing from the scope of this disclosure. In addition, in the drawings described below, components having the same function are denoted by the same reference numerals and signs, and thus the repeated description thereof will be omitted.

First Embodiment

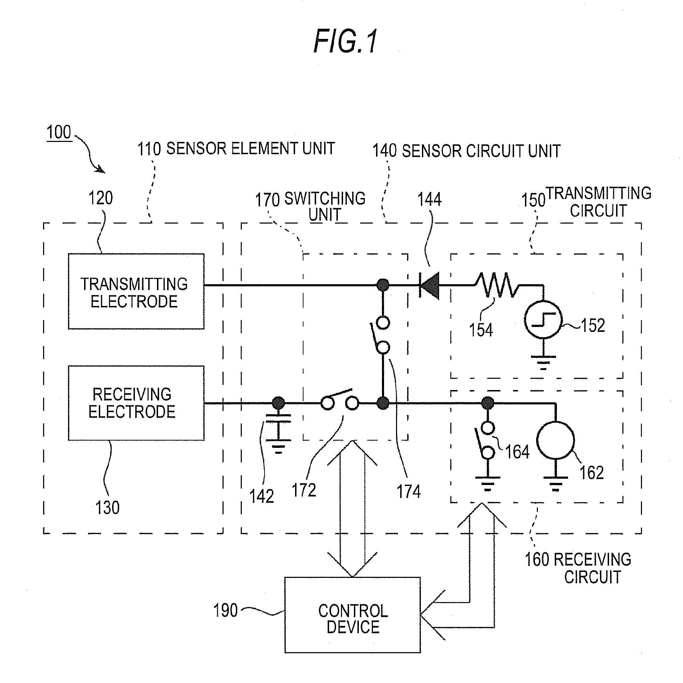

Fig. 1 is a block diagram illustrating a capacitance sensor according to an embodiment disclosed here. A capacitance sensor 100 includes a sensor element unit 110, a sensor circuit unit 140, and a control device 190, and the sensor element unit 110 and the sensor circuit unit 140 are connected to each other by a wiring. The sensor element unit 110 includes a transmitting electrode 120 and a receiving electrode 130. The transmitting electrode 120 and the receiving electrode 130 are connected to the sensor circuit unit 140. The transmitting electrode 120 is an electrode for generating an electric field between the transmitting electrode 120 and an object to be detected 200 or the receiving electrode 130, using a voltage applied from the sensor circuit unit 140. The receiving electrode 130 is an electrode for receiving an electric field generated by the transmitting electrode 120.

The sensor circuit unit 140 includes a transmitting circuit 150, a receiving circuit 160, a switching unit 170, a grounded capacitor 142 and a rectifying element 144. The transmitting circuit 150 includes a voltage source 152 and an internal resistance 154, and applies a voltage to the sensor element unit 110. The receiving circuit 160 includes a voltmeter 162 and a switch 164, and measures a voltage which is generated by charge accumulated in the sensor element unit 110 or the grounded capacitor.

The switching unit 170 includes switches 172 and 174. The switches 172 and 174 can switch the connection states thereof to an ON (short state) or an OFF (open state) depending on a signal from the outside. The switch 172 and the switch 174 are configured using, for example, a semiconductor switching element or the like. The switch 172 is disposed in a wiring located between the receiving electrode 130 and the receiving circuit 160, and can perform the switching of electrical connection between the receiving electrode 130 and the receiving circuit 160. The switch 174 is disposed in a wiring located between the transmitting electrode 120 and the receiving circuit 160, and can perform the switching of electrical connection between the transmitting electrode 120 and the receiving circuit 160. In addition, the transmitting electrode 120 and the rectifying element 144 are short-circuited.

The control device 190 is connected to the receiving circuit 160 and the switching unit 170. The control device 190 communicates with the receiving circuit 160 and the switching unit 170, and performs control. The control device 190 commands the receiving circuit 160 to perform detection to thereby acquire detection data, and performs the determination of a detection state on the basis of the detection data. The control device 190 controls the switching of the switches 172 and 174 included in the switching unit 170, on the basis of the determination result.

The grounded capacitor 142 is connected between a ground and a wiring which is located between the receiving electrode 130 and the switching unit 170. The grounded capacitor 142 has a function of temporarily accumulating charge generated in the transmitting electrode 120 or the receiving electrode 130 during the using of the capacitance sensor. The grounded capacitor 142 may be configured using a capacitive element such as a capacitor, and may causes a wiring or the like to function as the grounded capacitor 142 in an equivalent manner. For example, a parasitic capacitance is generated intentionally between the ground and the wiring which is located between the receiving electrode 130 and the switching unit 170, and thus can be used as a grounded capacitance.

The rectifying element 144 is constituted by a semiconductor diode or the like, and is connected between the transmitting circuit 150 and the switching unit 170. The anode of the rectifying element 144 is connected to the transmitting circuit 150, and the cathode thereof is connected to the switching unit 170. The rectifying element 144 prevents charge accumulated in the transmitting electrode 120, the receiving electrode 130 and the grounded capacitor 142 from flowing through the transmitting circuit 150. In the present embodiment, the rectifying circuit 144 is electrically connected between the transmitting circuit 150 and the switching unit 170, but the rectifying circuit 144 may be included in, for example, the inside of the transmitting circuit 150 or the inside of the switching unit 170.

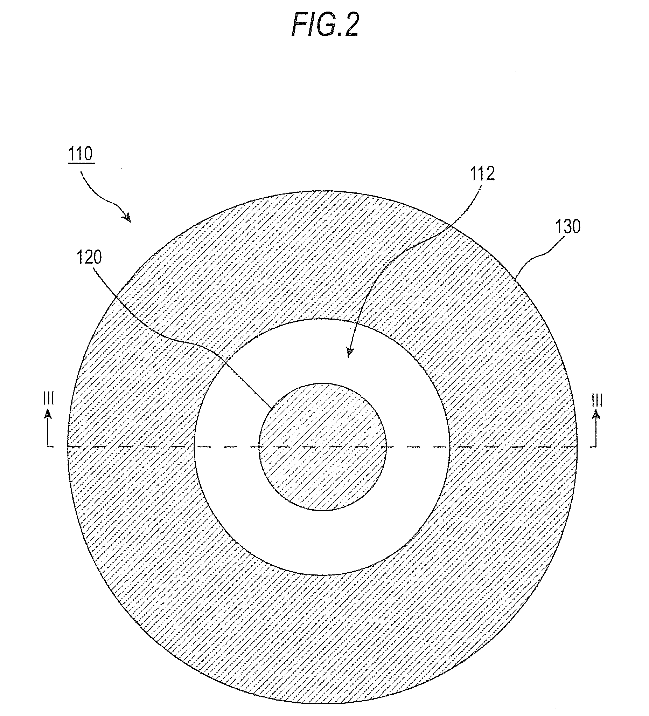

Fig. 2 is a schematic diagram illustrating the sensor element unit 110 according to an embodiment disclosed here. The sensor element unit 110 is circular in shape when seen in top view, and includes the transmitting electrode 120 and the receiving electrode 130 which are arranged side by side on the same plane. The transmitting electrode 120 is circular in shape, and the receiving electrode 130 is annular in shape. An interelectrode gap 112 is formed between the transmitting electrode 120 and the receiving electrode 130. The transmitting electrode 120 and the receiving electrode 130 include a conductor material such as a metal in order to cause a current to flow.

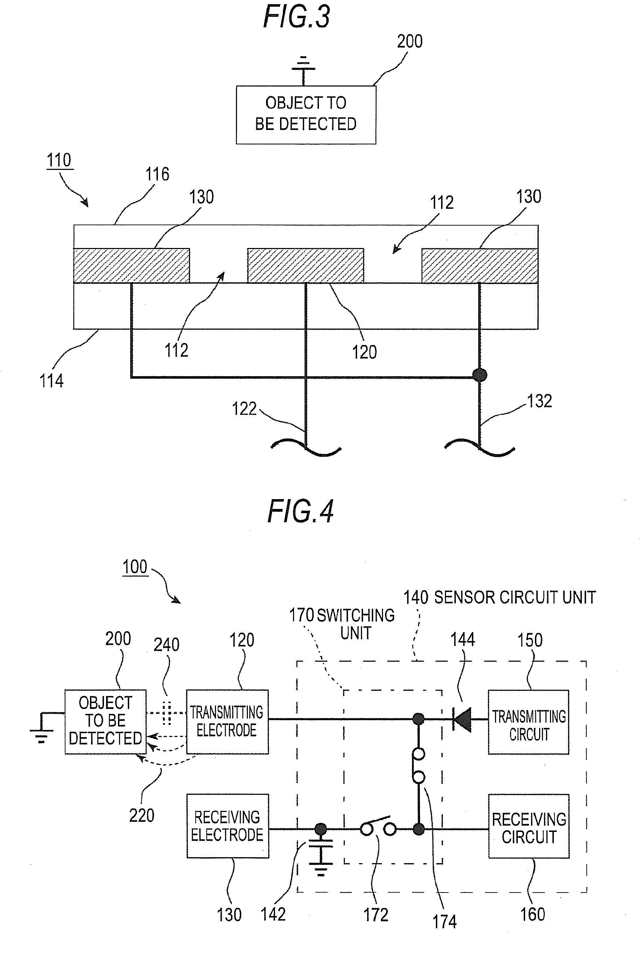

Fig. 3 is a cross-sectional view taken along line III-III of the sensor element unit 110 shown in Fig. 2. The transmitting electrode 120 and the receiving electrode 130 are formed on a base 114, and the transmitting electrode 120, the receiving electrode 130 and the base 114 are covered with a protective layer 116. The protective layer 116 prevents contamination and failure due to contact to the electrodes 120 and 130 or the like. Further, the protective layer 116 is provided, and thus it is possible to prevent measurement from not being capable of being performed due to the outflow of charge on an electrode to the object to be detected 200 when the object to be detected 200 comes into contact with the electrode. A non-conductive material is used in the base 114 and the protective layer 116. In order to enhance detection sensitivity, it is preferable that an electric field generated between the transmitting electrode 120 and the receiving electrode 130 be not concentrated inside the base 114 and the protective layer 116, and be widely distributed in the vicinity of the interelectrode gap 112 or in a space above the electrode. Therefore, it is suitable that a material having a low dielectric constant and a low electric conductivity be used in the base 114 and the protective layer 116. Specifically, it is possible to use materials, such as, for example, a resin and glass, having a low dielectric constant and a low electric conductivity. The transmitting electrode 120 and the receiving electrode 130 are extracted as a transmitting electrode terminal 122 and a receiving electrode terminal 132 to the outside of the sensor element 110 through an internal wiring, and are electrically connected to the sensor circuit unit 140.

Meanwhile, in the descriptions of Figs. 2 and 3, functions of the transmitting electrode and the receiving electrode may be reverse. That is, the electrode assigned sign 120 in the drawing may be a receiving electrode, and the electrode assigned sign 130 may be a transmitting electrode. In this example, the receiving electrode 120 is circular in shape, and the transmitting electrode 130 is annular in shape with the interelectrode gap 112 interposed therebetween. That is, the transmitting electrode 130 is disposed so as to surround the receiving electrode 120.

Fig. 4 is a diagram illustrating an operation in a self-capacitance detection mode in a capacitance sensor according to an embodiment disclosed here. In the circuit of Fig. 1, the switch 172 is set to be in an OFF-state, and the switch 174 is set to be in an ON-state. Thereby, the capacitance sensor 100 operates in a self-capacitance detection mode. When a voltage is applied from the transmitting circuit 150 to the transmitting electrode 120, charge is accumulated in the transmitting electrode 120, an electric field 220 is generated in the vicinity of the transmitting electrode 120. That is, a self-capacitor 240 is generated in the transmitting electrode 120. Since the transmitting electrode 120 is short-circuited to the receiving circuit 160, the self-capacitor 240 can be considered to be a capacitor formed between the receiving circuit 160 and a ground in an equivalent manner. Here, when the object to be detected 200 comes close to the vicinity of the electric field 220, the electric field 220 is concentrated between the transmitting electrode 120 and the object to be detected 200, the capacitance of the self-capacitor 240 increases as compared to a case where object to be detected 200 is not present. The receiving circuit 160 is used as a capacitance measurement circuit, and thus it is possible to measure the capacitance of the self-capacitor 240, and to detect a change in capacitance due to a change in the position of the object to be detected 200.

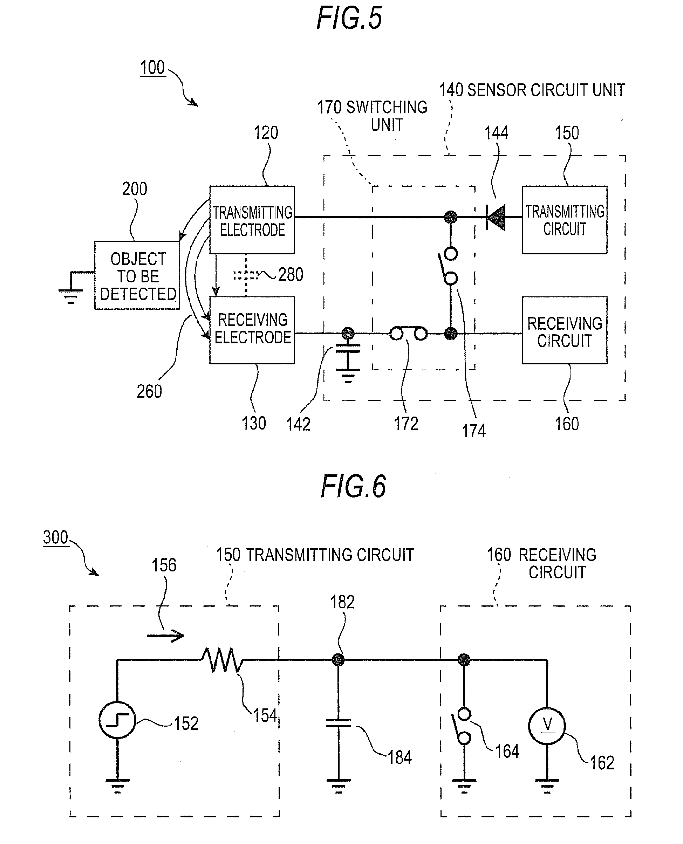

Fig. 5 is a diagram illustrating an operation in a mutual capacitance detection mode in a capacitance sensor according to an embodiment disclosed here. In the circuit of Fig. 1, the switch 172 is set to be in an ON-state, and the switch 174 is set to be in an OFF-state. Thereby, the capacitance sensor 100 operates in a mutual capacitance detection mode. When a voltage is applied from the transmitting circuit 150 to the transmitting electrode 120, charge is accumulated between the transmitting electrode 120 and the receiving electrode 130, and an electric field 260 is generated in the vicinities thereof. That is, a mutual capacitor 280 is generated in the receiving electrode 130. The mutual capacitor 280 can be considered to be a capacitor formed between the transmitting circuit 150 and the receiving circuit 160 in an equivalent manner. When the object to be detected 200 comes close to the vicinity of the electric field 260, a portion of the electric field 260 is directed to the object to be detected 200, the capacitance of the mutual capacitor 280 is reduced as compared to a case where the object to be detected 200 is not present. Here, the receiving circuit 160 is used as a capacitance measurement circuit, and thus it is possible to measure the capacitance of the mutual capacitor 280, and to detect a change in capacitance due to a change in the position of the object to be detected 200.

In this manner, in the capacitance sensor 100 shown in Fig. 1, the switch 172 and the switch 174 are switched, and thus it is possible to perform detection in two modes of the self-capacitance detection mode based on a change in the capacitance of the self-capacitor 240 and the mutual capacitance detection mode based on a change in the capacitance of the mutual capacitor 280.

Next, a description will be given of an example of capacitance measurement methods in the self-capacitance detection mode and the mutual capacitance detection mode. Fig. 6 shows an example of a capacitance measurement circuit simplified in order to describe a capacitance measurement principle. A capacitance measurement circuit 300 is a circuit for measuring the capacitance of a to-be-measured capacitor 184, and includes the transmitting circuit 150 and the receiving circuit 160. The transmitting circuit 150 includes the voltage source 152 and the internal resistance 154. The voltage source 152 and the internal resistance 154 are connected in series to each other, and can output a current 156 for accumulating charge in the to-be-measured capacitor 184 to a node 182 by applying a voltage. The receiving circuit 160 includes the voltmeter 162 and the switch 164. The voltage of the node 182 of the circuit which is generated by charge accumulated in the to-be-measured capacitor 184 can be measured by the voltmeter 162 which is electrically connected to the node 182. The switch 164 is for opening the charge accumulated in the to-be-measured capacitor 184 and returning the capacitance measurement circuit 300 to an initial state.

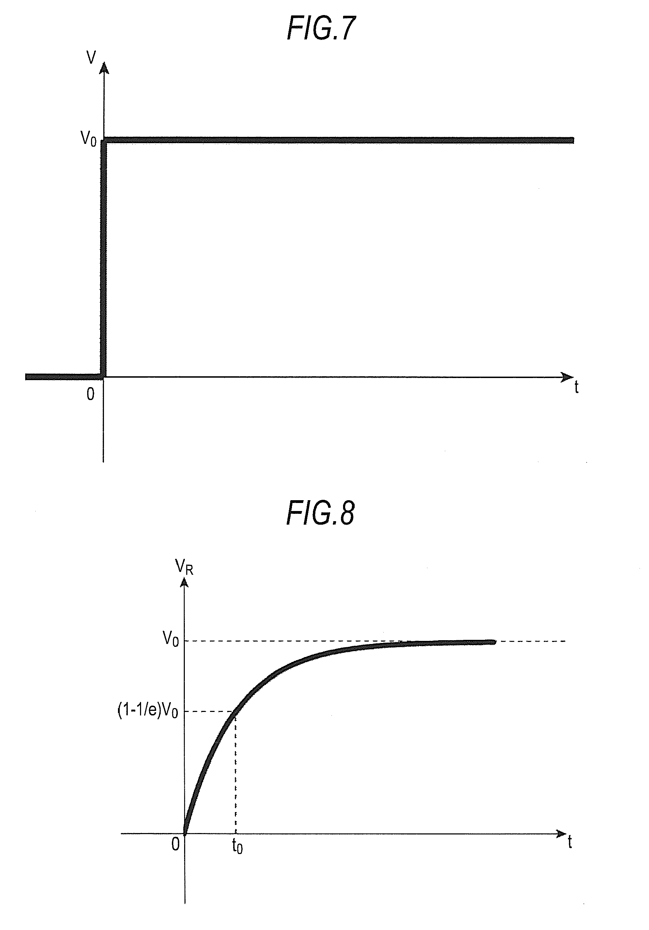

Next, a principle of capacitance measurement using the capacitance measurement circuit 300 will be described. In order to start the measurement, time t at which the application of a voltage from the voltage source 152 is started is set to t=0. In this case, a graph in which the horizontal axis is set to a time and the vertical axis is set to a voltage V applied by the voltage source 152 has a step function as shown in Fig. 7. That is, the relation of V=0 at t<0 and V=$V_0$ at t≥0 is established. Here, when the resistance value of the internal resistance 154 is set to R, the current 156 is set to I(t), the capacitance of the to-be-measured capacitor 184 is set to C, and the charge accumulated in the to-be-measured capacitor 184 is set to Q(t), the following Expression (1) is established by the Kirchhoffs second law.

$$RI(t) + \frac{Q(t)}{C} = V_0 \qquad (1)$$

Here, the current I(t) is generally defined by the time differentiation of the charge Q(t), and thus the following Expression (2) is established.

$$I(t) = \frac{dQ(t)}{dt} \qquad (2)$$

When Expression (2) is substituted into Expression (1), the following Expression (3) is obtained.

$$R\frac{dQ(t)}{dt} + \frac{Q(t)}{C} = V_0 \qquad (3)$$

When Expression (3) which is a differential equation with respect to the time t is solved for the charge Q(t) accumulated in the to-be-measured capacitor 184, the temporal change of the charge Q(t) is obtained as the following Expression (4).

$$Q(t) = CV_0(1 - \exp(-\frac{t}{CR})) \qquad (4)$$

When the voltage of the node 182 which is measured by the voltmeter 162 is set to $V_R(t)$, the relation of $V_R(t)$ $V_R(t)$=Q(t)/C is established, and $V_R(t)$ is given by the following Expression (5).

$$V_R(t) = V_0(1 - \exp(-\frac{t}{CR})) \qquad (5)$$

From Expression (5), a graph in which the horizontal axis is set to time t and the vertical axis is set to voltage $V_R(t)$ measured by the voltmeter 162 is shown in Fig. 8. It can be understood from Fig. 8 that charge is gradually accumulated with the lapse of time and a voltage rises toward a constant value. In addition, it can also be understood that the speed of a rise in voltage is determined by setting time constant $t_0$=CR to a parameter. The circuit is a measurement circuit of the capacitance sensor. Therefore, considering that R is a constant and C is a variable, it may be said that as the capacitance C of the to-be-measured capacitor 184 increases, the accumulation of charge becomes slower and a rise in voltage becomes slower. Reversely, as the capacitance C of the to-be-measured capacitor 184 decreases, the accumulation of charge becomes faster and a rise in voltage becomes faster. That is, the charging time of the to-be-measured capacitor 184, that is, the time taken to reach a predetermined voltage after the start of the application of a voltage is changed on the basis of the value of the capacitance C of the to-be-measured capacitor 184. From the above, it may be said that the capacitance of the to-be-measured capacitor 184 can be calculated by measuring the charging time.

After the above-mentioned measurement is performed and the elapsed time is measured, the entire circuit is set to have the same potential as that of a ground by setting the switch 164 to be in an ON-state, and then the charge accumulated in the to-be-measured capacitor 184 is opened to the ground. Thereafter, the switch 164 is set to be in an OFF-state again, and thus the switch can be returned (reset) to a state in which the measurement can be performed again. The circuit is configured such that the measurement and reset are repeated automatically, and the capacitance of the to-be-measured capacitor 184 is measured repeatedly, thereby allowing a change in capacitance to be measured in real time.

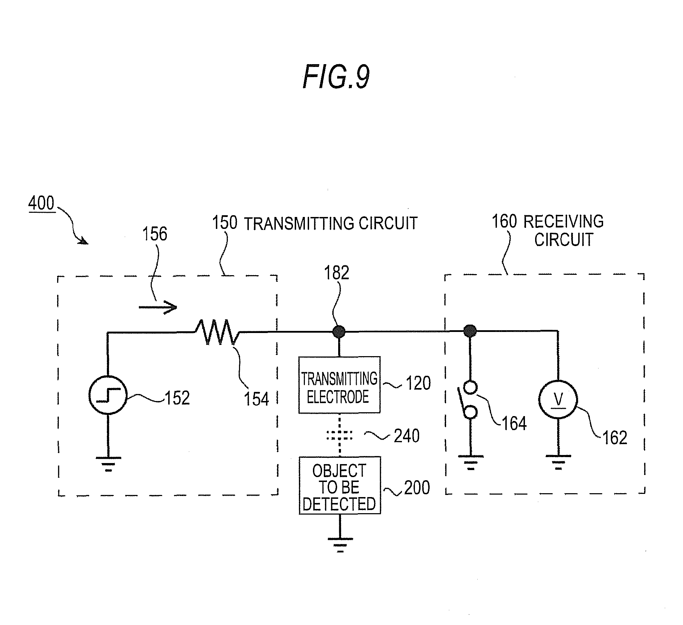

An equivalent circuit of the self-capacitance detection mode is shown in Fig. 9. The equivalent circuit of Fig. 9 is the same as obtained by replacing the to-be-measured capacitor 184 of Fig. 6 with the self-capacitor 240. Therefore, when the capacitance value of the self-capacitor 240 is set to $C_S$, $C_S$ is substituted into C of Expression (5) in the self-capacitance detection mode, and thus the voltage $V_R(t)$ which is measured by the voltmeter 162 is given by the following Expression (6).

$$V_R(t) = V_0 (1 - \exp(-\frac{t}{C_S R})) \qquad (6)$$

In self-capacitance detection mode, when the object to be detected comes close, the value $C_S$ of the capacitance of the self-capacitor 240 increases. Then, the time constant $t_0 = C_S R$ increases from Expression (6), and thus the charging time of a voltage becomes longer. Therefore, it is possible to detect that the object to be detected comes close by measuring the charging time.

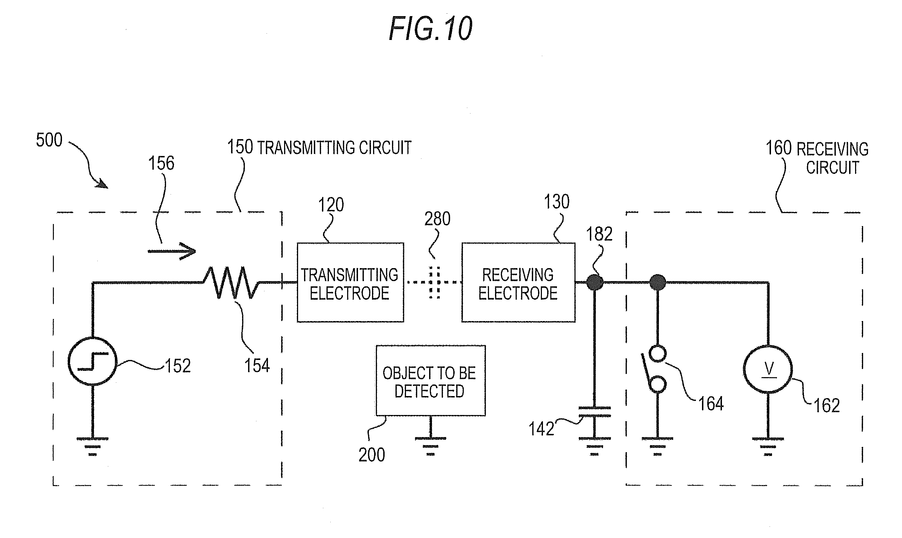

An equivalent circuit in the mutual capacitance detection mode is shown in Fig. 10. The equivalent circuit of Fig. 10 is obtained by replacing the to-be-measured capacitor 184 with the aforementioned grounded capacitor 142, and adding the mutual capacitor 280 in series. Therefore, when the capacitance value of the grounded capacitor 142 is set to $C_G$, the capacitance value of the mutual capacitor 280 is set to $C_M$, and the voltage $V_R(t)$ which is measured by the voltmeter 162 is derived similarly, the following Expression (7) is established. Herein, $C_C$ in Expression (7) is a serial resultant capacitance of the grounded capacitor 142 and the mutual capacitor 280 which is calculated by Expression (8).

$$V_R(t) = \frac{C_C}{C_G} V_0 (1 - \exp(-\frac{t}{C_C R})) \qquad (7)$$

$$\frac{1}{C_C} = \frac{1}{C_G} + \frac{1}{C_M} \qquad (8)$$

In the mutual capacitance detection mode, when the object to be detected comes close, the capacitance value $C_M$ of the mutual capacitor 240 becomes smaller. Then, from Expression (7) and Expression (8), the time constant $t_0 = C_C R$ becomes smaller, and thus the elapsed time to reach a predetermined voltage after the start of the application of a voltage is shortened. Therefore, it is possible to detect that the object to be detected comes close by measuring the elapsed time.

In this manner, the switching between the self-capacitance detection mode and the mutual capacitance detection mode can be performed only by the switching of the switching unit 170. In either detection mode, measurement is performed on a change in elapsed time to reach a predetermined voltage from the start of voltage application depending on a change in self-capacitance or mutual capacitance, and thus it is possible to detect that the object to be detected 200 comes close. Therefore, it is possible to realize detection based on a plurality of modes using the same circuit configuration.

In two modes of the self-capacitance detection mode and the mutual capacitance detection mode, as a method of measuring a change in capacitance using the object to be detected 200, a method of performing measurement depending on a change in charging time has been described as an example, a configuration or means for further enhancing the accuracy of measurement may be added. For example, it is possible to measure a plurality of voltage values using a plurality of receiving electrodes 130 by providing the receiving electrodes 130, and to calculate and correct a systematic error due to a background capacitance by obtaining a difference therebetween. In addition, it is also possible to reduce the error by obtaining an average value of the plurality of voltage values. As another example, it is also possible to amplify measured voltage values by adding an amplifier such as an operational amplifier to the receiving circuit 140, and to improve accuracy by enhancing a measurement resolution.

The measurement of the capacitance in each mode can also be performed by replacement with other various known methods. For example, it is possible to use a method of calculating a capacitance by measuring an oscillation frequency changing depending on the capacitance through the connection of an oscillation circuit. As another example, a method can also be used in which a step of transferring the charge accumulated in the to-be-measured capacitor to a capacitive element having another known capacitance is repeatedly performed by a switching circuit, and a capacitance is calculated on the basis of the number of times of steps until predetermined charge is accumulated.

In the present embodiment, an example is illustrated in which one transmitting circuit 150 and one receiving circuit 160 are provided, but a plurality of transmitting circuits 150 and/or receiving circuits 160 may be provided. In each mode of the self-capacitance detection mode and the mutual capacitance detection mode, a different transmitting circuit 150 and/or a different receiving circuit 160 is used, thereby allowing an optimum circuit to be used for each mode.

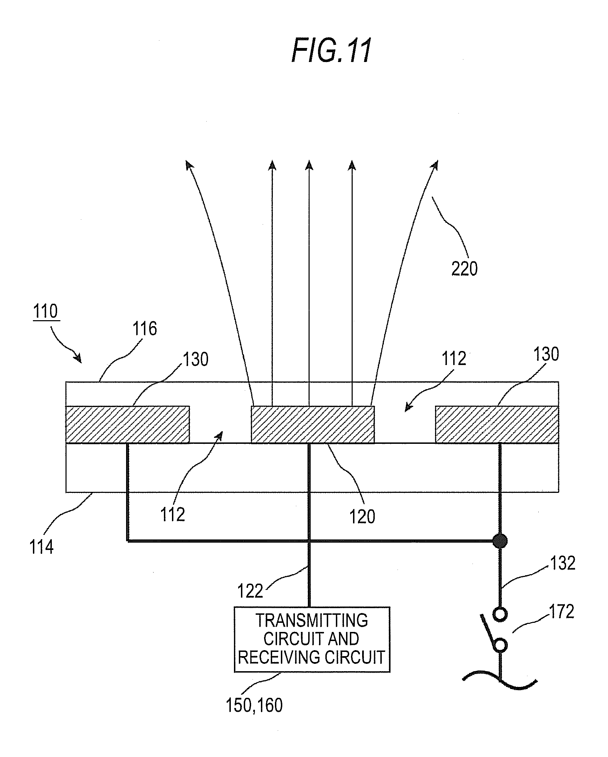

Next, a further detailed description will be given of features of the self-capacitance detection mode and the mutual capacitance detection mode by indicating the distribution of an electric field with reference to the element structure of the sensor element unit of the capacitance sensor according to an embodiment disclosed here. Fig. 11 is a schematic diagram illustrating an electric field distribution in the self-capacitance detection mode, in the cross-sectional view taken along line XI-XI of the sensor element unit. When a voltage is applied from the transmitting circuit 150 to the transmitting electrode 120, charge is accumulated in the transmitting electrode 120, and the electric field 220 is emitted toward the upper surface of the sensor element unit 110.

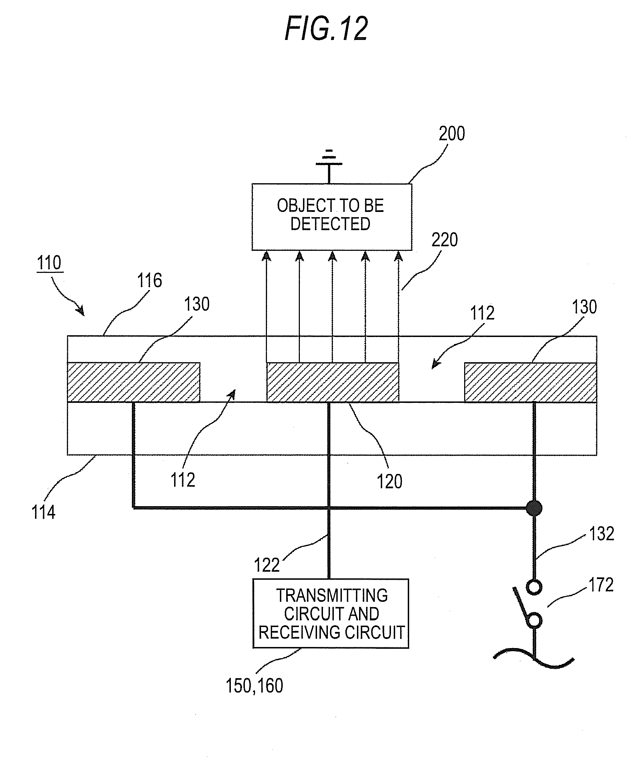

Fig. 12 is a schematic diagram illustrating an electric field distribution when the object to be detected 200 is brought close to a sensor element unit shown in Fig. 11. When the object to be detected 200 comes close to the transmitting electrode 120, the electric field 220 is concentrated between the object to be detected 200 and the transmitting electrode 120, and electric flux density increases. For this reason, the amount of charge capable of being accumulated in the transmitting electrode 120 increases, and the self-capacitance of the transmitting electrode 120 increases.

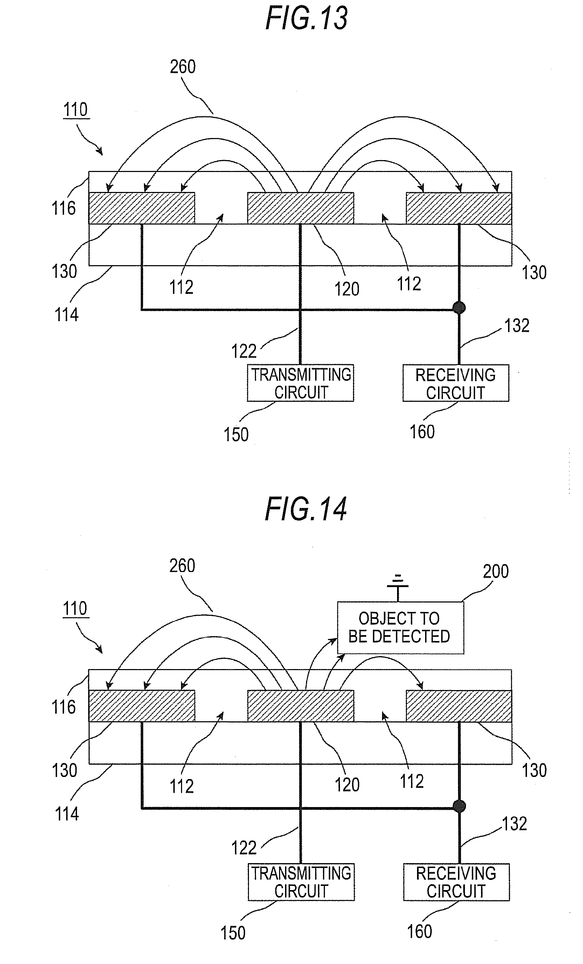

Fig. 13 is a schematic diagram illustrating an electric field distribution in the mutual capacitance detection mode, in the cross-sectional view taken along line XIII-XIII of the sensor element unit. When a voltage is applied from the transmitting circuit 150 to the transmitting electrode 120, charge is accumulated in the transmitting electrode 120, and the electric field 260 is emitted toward the receiving circuit 160.

Fig. 14 is a schematic diagram illustrating an electric field distribution when the object to be detected 200 is brought close to the sensor element unit 110 shown in Fig. 13. When the object to be detected 200 comes close to the vicinity of the transmitting electrode 120 or the receiving electrode 130, the object to be detected 200 blocks the electric field 260 generated between the transmitting electrode 120 and the receiving electrode 130, and the electric field reaching the receiving electrode 130 is reduced. For this reason, the amount of charge capable of being accumulated between the transmitting electrode 120 and the receiving electrode 130 increases, and a mutual capacitance between the transmitting electrode 120 and the receiving electrode 130 is reduced.

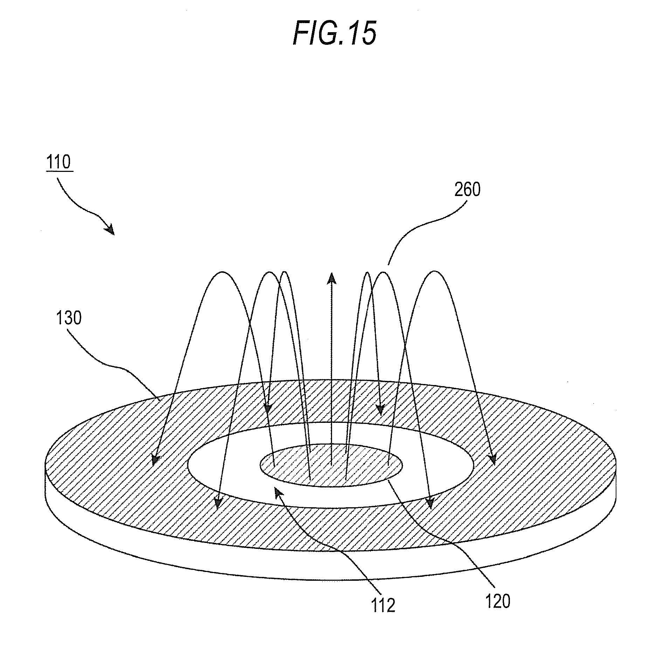

Fig. 15 is a perspective view of the sensor element unit 110 illustrating the distribution of the electric field 260 in the mutual capacitance detection mode. Since transmitting electrode 120 is circular in shape which is axially symmetric, the electric field 260 is distributed uniformly over the entire circumference. Thereby, the resultant vector of the electric field 260 which is output from the transmitting electrode 120 is directed to a direction vertical to the transmitting electrode 120, and thus a variation in sensitivity over the entire circumference of the electrode can be reduced. In addition, since the component of the electric field 260 in a vertical direction can be increased, it is possible to increase the distance of the capacitance sensor 100 which is capable of being detected in a vertical direction. Meanwhile, it is preferable that the central axes of the outer circumference of the circular transmitting electrode 120 and the inner circumference of the receiving electrode 130 be coincident with each other, that is, be concentric with each other. Thereby, the width of the interelectrode gap 112 becomes uniform, and the density of line of electric force becomes more uniform over the entire circumference.

As described above, both the self-capacitance detection mode and the mutual capacitance detection mode are coincident with each other in that a change in capacitance depending on the object to be detected 200 coming close is detected, but vary greatly in the spatial distribution of the electric field. In the self-capacitance detection mode, the electric field 220 generated from the transmitting electrode 120 is distributed radially, and thus the object to be detected 200 which is located at a distant place can be detected. On the other hand, in the mutual capacitance detection mode, the electric field 260 is distributed so as to be directed from the transmitting electrode 120 toward the receiving electrode 130, and thus high detection sensitivity can be obtained in the vicinity of the transmitting electrode 120. According to the present embodiment, the self-capacitance detection mode and the mutual capacitance detection mode having such different features can be switched and used as necessary.

Second Embodiment

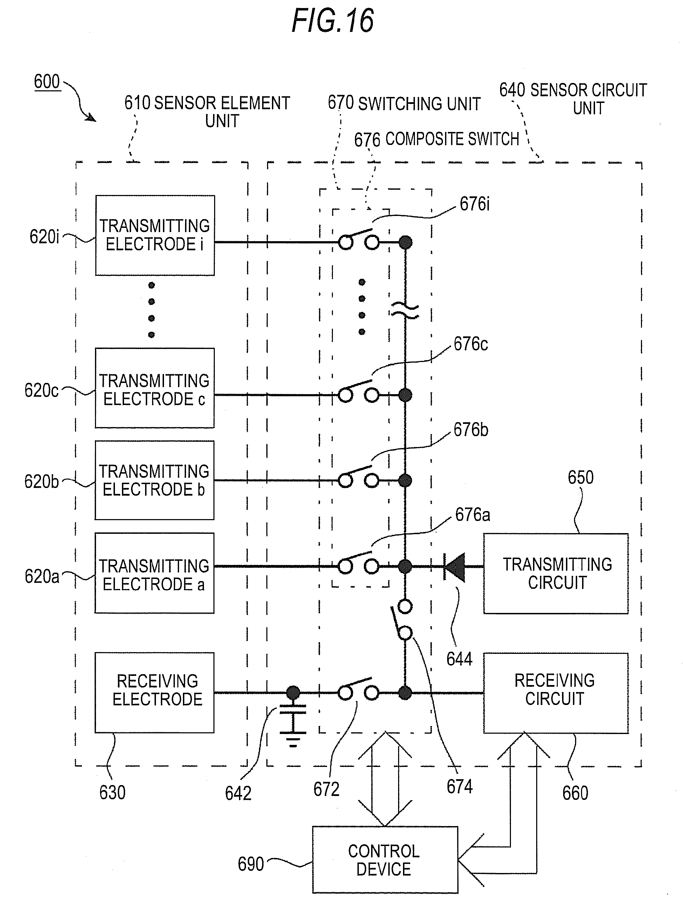

Subsequently, a capacitance sensor according to another embodiment is shown in Figs. 16 to 18.

Fig. 16 is a block diagram illustrating a capacitance sensor 600 according to another embodiment disclosed here. The capacitance sensor 600 according to the present embodiment includes a plurality of transmitting electrodes 620a to 620i, and a composite switch 676 constituted by switches 676a to 676i. The switches 676a to 676i are connected between the transmitting electrodes 620a to 620i and a transmitting circuit 650. The switching between the self-capacitance detection mode and the mutual capacitance detection mode can be performed by switching the turn-on or turn-off of a switch 672, a switch 674 and the composite switch 676.

The capacitance sensor 600 is set to be in the self-capacitance detection mode by turning off the switch 672, turning on the switch 674, and turning on the switches 676a to 676i. All the transmitting electrodes 620 operate as electrodes that detect the capacitance of the self-capacitor 240. Since all of a plurality of transmitting electrodes 620 have the same potential, the value of the self-capacitor 240 can be made larger, and thus detection sensitivity becomes satisfactory. Therefore, the capacitance sensor 600 is used in the self-capacitance detection mode, thereby allowing the object to be detected 200 which is located at a distant place to be detected. Meanwhile, the entirety of the composite switch 676 may be not necessarily turned on, and detection sensitivity can be adjusted to appropriate strength by turning off a portion of the composite switch.

The capacitance sensor 600 is set to be in the mutual capacitance detection mode by turning on the switch 672, turning off the switch 674, and turning on one of the switches 676a to 676i. in this manner, it is possible to detect a mutual capacitance between one of the transmitting electrodes 620a to 620i and a receiving electrode 630. Since only one electrode of the plurality of transmitting electrodes 620a to 620i which is connected to one switch set to be in an ON-state has receiving sensitivity, detection is performed only when the object to be detected 200 is located in the vicinity of the corresponding electrode. Which electrode the object to be detected 200 exists near is detected by switching one switch of the switches 676a to 676i which is set to be in an ON-state in order and sequentially performing measurement in each of the transmitting electrodes 620a to 620i. In this manner, the capacitance sensor 600 is used in the mutual capacitance detection mode, thereby allowing the position of the object to be detected 200 to be detected. In addition, this detection is performed repeatedly continuously, and thus the capacitance sensor can be used as a motion sensor that detects the movement of the object to be detected 200.

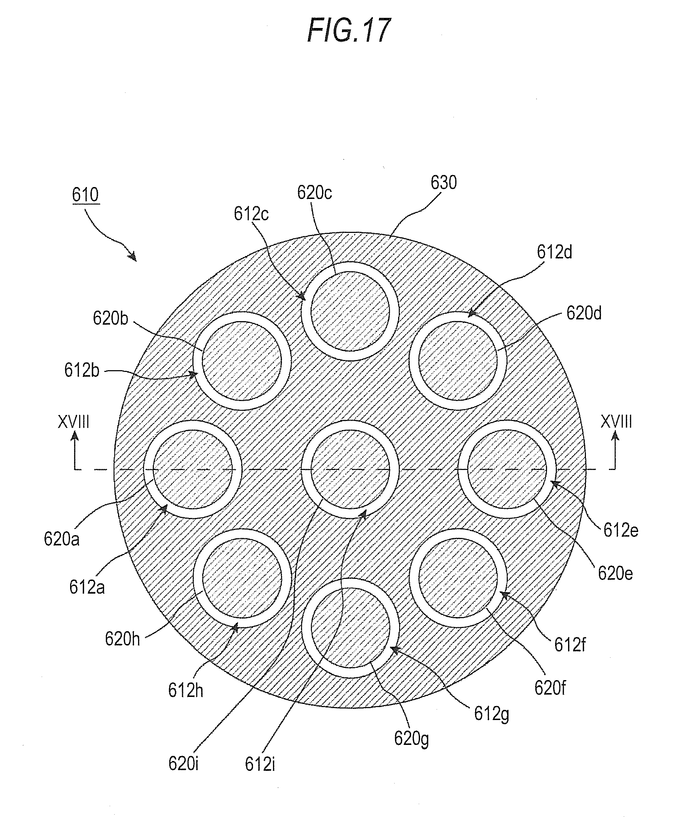

Fig. 17 is a schematic diagram illustrating a sensor element unit 610 according to a second embodiment disclosed here. The sensor element unit 610 includes a plurality of transmitting electrodes 620a to 620i, the receiving electrode 630, and a plurality of interelectrode gaps 612a to 612i between a plurality of transmitting electrodes 620a to 620i and the receiving electrode 630. The plurality of transmitting electrodes 620a to 620i are disposed radially. It is preferable that gaps between each of the transmitting electrodes 620a to 620i be uniform. For example, these transmitting electrodes may be disposed in a lattice shape. Measurement performed by each of the transmitting electrodes 620a to 620i in the mutual capacitance detection mode is performed in order, and thus it is possible to detect which electrode the object to be detected 200 is located near.

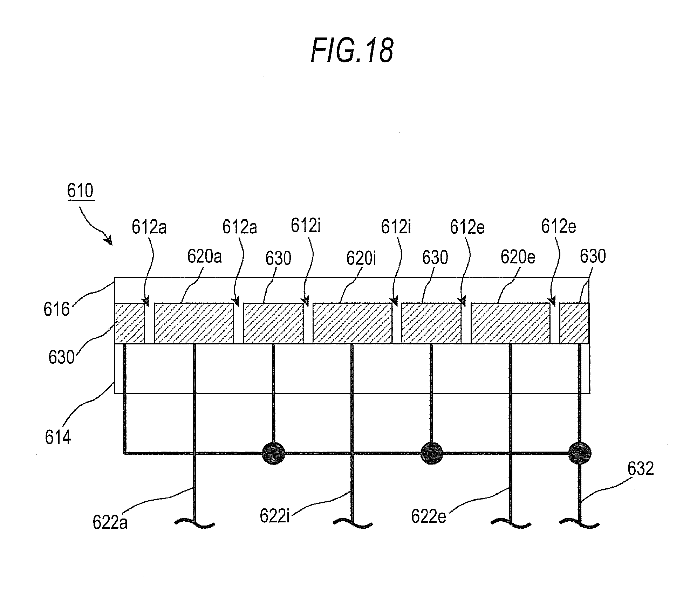

Fig. 18 is a cross-sectional view taken along line XVIII-XVIII of a sensor element unit shown in Fig. 17. The element structure except for the arrangement of the electrodes is the same as that of the sensor element unit shown in Fig. 10. Each of the transmitting electrodes 620a to 620i and the receiving electrode 630 are extracted as each of transmitting electrode terminals 622a to 622i and a receiving electrode terminal 632 through internal wirings to the outside of the sensor element 610, and are electrically connected to a sensor circuit unit 640.

Meanwhile, in the descriptions of Figs. 16 to 18, the functions of the transmitting electrode and the receiving electrode may be reverse. That is, the electrode assigned signs 620a to 620i in the drawing may be receiving electrodes, and the electrode assigned sign 630 may be a transmitting electrode. In this case, since a plurality of receiving electrodes 620a to 620i are provided, the switches 676a to 676i are connected to a plurality of receiving electrodes.

According to the present embodiment, it is possible to perform both the detection of the object to be detected which is located at a position distant from the capacitance sensor and the detection of the movement of the object to be detected which is located near the capacitance sensor.

Meanwhile, the switching between the self-capacitance detection mode and the mutual capacitance detection mode may be manually performed on the basis of a user's operation, and may be automatically executed by a control device 690 capable of executing a predetermined algorithm. The control device 690 is configured to perform switching control of the switches 672, 674, and 676a to 676i on the basis of the detection result by a logic circuit, a program and the like.

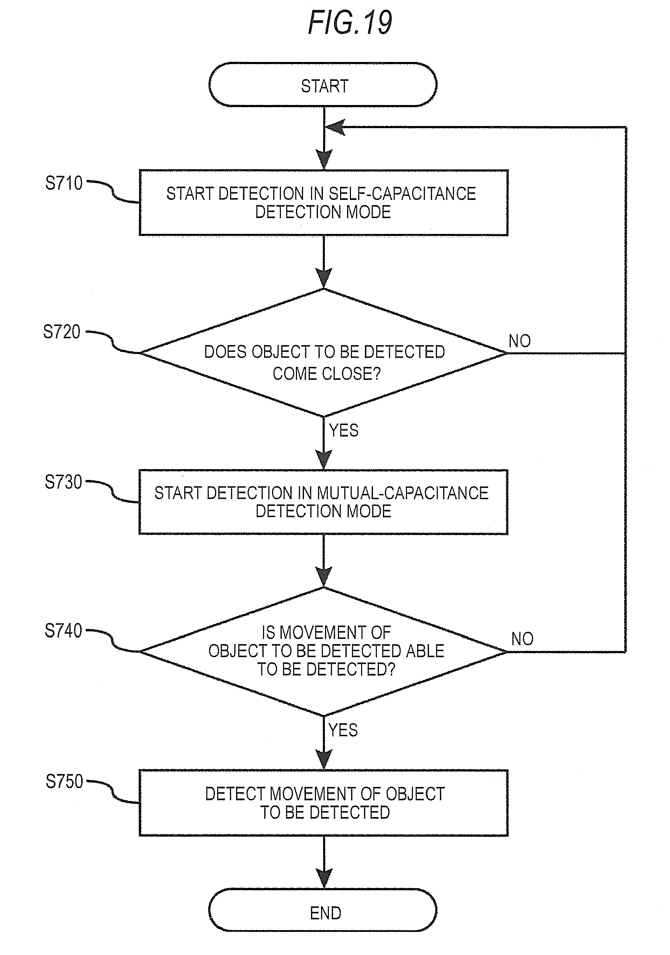

Fig. 19 shows an example of a flow diagram of an algorithm relating to the switching between the self-capacitance detection mode and the mutual capacitance detection mode. In an initial state, the capacitance sensor 600 performs detection using the self-capacitance detection mode (S710). The control device 690 determines whether the object to be detected 200 comes closer than a predetermined distance on the basis of the detection data (S720). When the object to be detected 200 is detected, the control device 690 performs the switching control of the switches 672, 674, and 676a to 676i, and performs switching to the mutual capacitance detection mode (S730). When the object to be detected 200 is not detected, the control device 690 determines the object to be detected 200 not to be located near the capacitance sensor 600, and detection in the self-capacitance detection mode is continued.

When the object to be detected 200 is detected, detection in the mutual capacitance detection mode is started. The control device 690 determines whether the movement of the object to be detected 200 is able to be detected on the basis of detection data (S740). When the control device 690 determines that the movement of the object to be detected 200 is able to be detected, the capacitance sensor 600 continues the detection of the movement of the object to be detected 200 (S750). When the object to be detected 200 is not detected by the capacitance sensor 600 even in a case where the movement of the object to be detected 200 is not able to be detected, that is, any of the transmitting electrode terminals 622a to 622i is used as a transmitting electrode, the control device 690 determines that the object to be detected 200 is distant from the capacitance sensor 600, and switches the capacitance sensor 600 to the self-capacitance detection mode again. In this manner, the control device 690 selects an optimum detection mode automatically in accordance with a distance between the object to be detected 200 and the capacitance sensor 600, or the like. As a result, the capacitance sensor 600 can detect the approach or movement of the object to be detected 200 using the optimum detection mode.

Other Embodiments

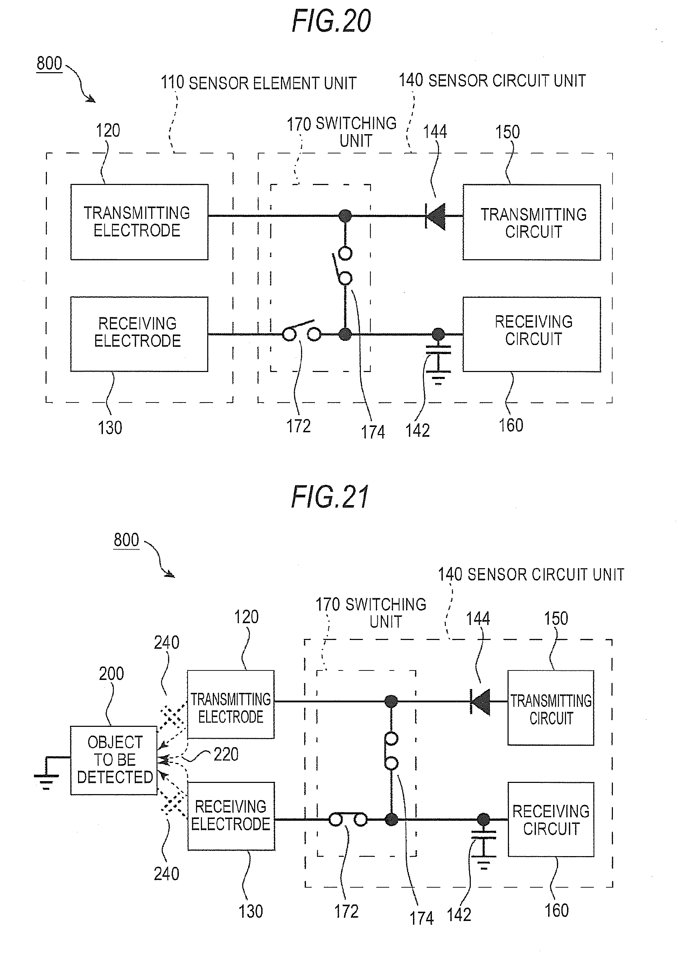

Fig. 20 is a block diagram illustrating a capacitance sensor 800 according to another embodiment disclosed here. In the block diagram of the capacitance sensor of Fig. 1, the grounded capacitor 142 is disposed between the receiving electrode 130 and the switching unit 170. However, in the embodiment of Fig. 20, the grounded capacitor 142 is disposed between the switching unit 170 and the receiving circuit 160. In this block diagram, similarly to Fig. 1, the use based on the self-capacitance detection mode or the mutual capacitance detection mode is possible by setting the switch 172 and the switch 174. However, in the present embodiment, both the switch 172 and the switch 174 are set to be in an ON-state, thereby allowing the use based on a second self-capacitance detection mode to be achieved. Fig. 21 shows an operation diagram based on the second self-capacitance detection mode. Both the switch 172 and the switch 174 are set to be in an ON-state and thus the potentials of both the transmitting electrode 120 and the receiving electrode 130 become equal to each other. For this reason, both the transmitting electrode 120 and the receiving electrode 130 function as electrodes that generate the self-capacitor 240, and thus the capacitance value of the self-capacitor 240 can be made larger than in a case of the self-capacitance detection mode shown in Fig. 2. Therefore, the embodiment exhibits an effect that the detection sensitivity of the capacitance sensor is further improved in the second self-capacitance detection mode.

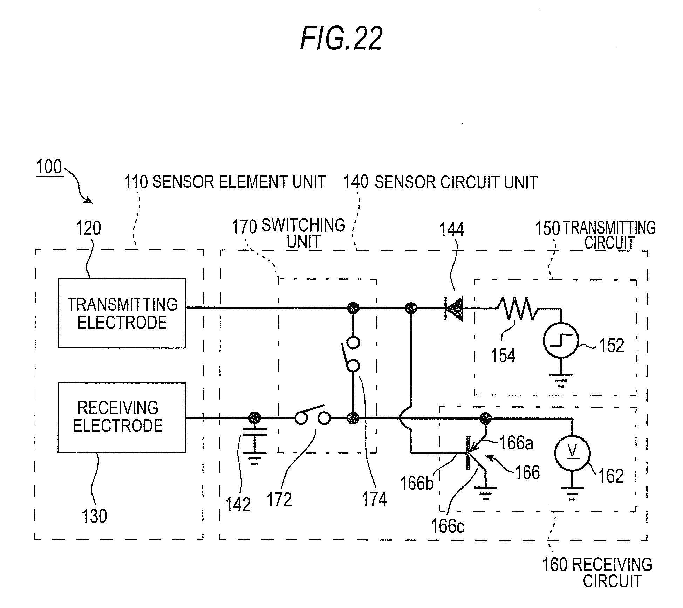

Fig. 22 is a block diagram illustrating an example in which a reset circuit is configured using a transistor. In the above-mentioned embodiment of Figs. 1 and 6 and the like, the receiving circuit 160 includes the switch 164, and the circuit is return (reset) to an initial state by switching the switch 164 to thereby cause the accumulated charge to flow to the ground. On the other hand, in the example of Fig. 22, the switch 164 is replaced with a transistor 166 to form a reset circuit. The transistor 166 is a PNP-type bipolar transistor, and includes an emitter terminal 166a, a base terminal 166b, and a collector terminal 166c. the emitter terminal 166a is connected to a voltage source 162 within the receiving circuit 160, the base terminal 166b is connected to a voltage source 152 within the transmitting circuit 150, and the collector terminal 166c is connected to a ground.

Since a voltage is applied to the base terminal 166b from the transmitting circuit 150 while performing detection using the capacitance sensor 100, charge almost does not flow in the direction of the collector terminal 166c from the emitter terminal 166a. When the voltage applied from the transmitting electrode 150 is reduced at the time of the reset of the circuit, the voltage of the base terminal 166b is lower than that of the emitter terminal 166a, and thus a current flows in the direction of the collector terminal 166c from the emitter terminal 166a. That is, charge accumulated in the transmitting electrode 120, the receiving electrode 130, the grounded capacitor 142 and the like is caused to flow to the ground, and thus the circuit can be reset. In this manner, the transistor 166 can be operated by a voltage which is applied from the transmitting circuit.

In this manner, in the example of Fig. 22, the reset of the circuit can be realized. Since the voltage which is applied from the transmitting circuit 150 can be used for the operation of the transistor 166 by using such a configuration, there is an advantage that an additional signal circuit is not required to be provided in order to reset the circuit. Meanwhile, in order to facilitate the description, an example is shown in which a bipolar transistor is used in the transistor 166. However, even when another type of transistor such as a field effect transistor is used, the reset of the circuit can be realized similarly.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the scope of the present invention. Accordingly, it is expressly intended that all such variations, changes and equivalents which fall within the scope of the present invention as defined in the claims, be embraced thereby.

**Claims**

1. A capacitance sensor (100, 600, 800) comprising:

   a transmitting electrode (120, 620a to 620i);
   a receiving electrode (130, 630);
   **characterized in that** it comprises a switching unit (170, 670) for performing switching between a self-capacitance detection mode for measuring a change in self-capacitance of at least one of the transmitting electrode and the receiving electrode to detect an object to be detected (200) and a mutual capacitance detection mode for measuring a change in mutual capacitance between the transmitting electrode and the receiving electrode to detect an object to be detected.

2. The capacitance sensor according to claim 1, further comprising a grounded capacitor (142, 642) which is electrically connected between the transmitting electrode (120, 620a to 620i) or the receiving electrode (130, 630) and a ground.

3. The capacitance sensor according to claim 2, wherein the measurement of the self-capacitance and the mutual capacitance is performed by measuring a charging time of charge which is charged when a voltage is applied to at least one of the self-capacitor, the mutual capacitor, and the grounded capacitor (142, 642).

4. The capacitance sensor according to any one of claims 1 to 3, wherein a plurality of the transmitting electrodes or a plurality of the receiving electrodes are provided, and the capacitance sensor further comprises a plurality of switches (164, 172, 174, 672, 674, 676a to 676i) which are respectively connected to the plurality of transmitting electrodes or the plurality of receiving electrodes.

5. The capacitance sensor according to claim 4, wherein in the measurement in the mutual capacitance detection mode, the measurement of the mutual capacitance between each transmitting electrode (120, 620a to 620i) and the receiving electrode (130, 630) is performed by closing the plurality of switches in order.

6. The capacitance sensor according to any one of claims 1 to 5, wherein the transmitting electrode and the receiving electrode are arranged side by side on the same plane of the same base with an interelectrode gap (112, 612a to 612i) interposed therebetween.

7. The capacitance sensor according to claim 6, wherein the receiving electrode is disposed so as to surround the transmitting electrode, or the transmitting electrode is disposed so as to surround the receiving electrode.

8. The capacitance sensor according to any one of claims 1 to 7, wherein the transmitting electrode has a circular shape.

9. The capacitance sensor according to any one of claims 6 to 8, wherein the interelectrode gap has an annular shape with a uniform width.

10. The capacitance sensor according to any one of claims 1 to 9, wherein the switching unit (670) is configured to perform switching to the mutual capacitance detection mode, using detection of the object to be detected (200) coming close during detection based on the self-capacitance detection mode as a trigger.

11. The capacitance sensor according to any one of claims 1 to 10, wherein the switching unit (670) is configured to perform switching to the self-capacitance detection mode, using none-detection of movement of the object to be detected during detection based on the mutual capacitance detection mode as a trigger.

# FIG.1

# FIG.2

## FIG.3

OBJECT TO
BE DETECTED 200

110

116

130

112

130

114

112

120

122

132

## FIG.4

100

200 OBJECT TO BE DETECTED

240

120 TRANSMITTING ELECTRODE

170 SWITCHING UNIT

140 SENSOR CIRCUIT UNIT

144

150 TRANSMITTING CIRCUIT

220

130 RECEIVING ELECTRODE

142

172

174

160 RECEIVING CIRCUIT

# FIG.5

100

200

120

140 SENSOR CIRCUIT UNIT

170 SWITCHING
UNIT

144

150

OBJECT
TO BE
DETECTED

TRANSMITTING
ELECTRODE

TRANSMITTING
CIRCUIT

280

RECEIVING
ELECTRODE

RECEIVING
CIRCUIT

260

130   142

172

174

160

# FIG.6

300

156

150 TRANSMITTING CIRCUIT

160  RECEIVING
CIRCUIT

182

152

154

184

164

162

## FIG.7

## FIG.8

# FIG.9

400

156

150 TRANSMITTING CIRCUIT

160 RECEIVING CIRCUIT

182

TRANSMITTING ELECTRODE ~120

~152    154

~240

OBJECT TO BE DETECTED ~200

164

V 162

FIG.10

EP 2 833 551 A1

# FIG.11

TRANSMITTING
CIRCUIT AND
RECEIVING CIRCUIT

# FIG.12

OBJECT TO BE
DETECTED

200

110

116

130

220

112

130

114

112

120

122

TRANSMITTING
CIRCUIT AND
RECEIVING CIRCUIT

150,160

132

172

## FIG.13

260

110

116

130

114

112

120

112

130

122

132

TRANSMITTING
CIRCUIT

RECEIVING
CIRCUIT

150

160

## FIG.14

260

110

200

OBJECT TO
BE DETECTED

116

130

114

112

120

112

130

122

132

TRANSMITTING
CIRCUIT

RECEIVING
CIRCUIT

150

160

## FIG.15

110

260

130

112

120

## FIG.16

# FIG.17

# FIG.18

# FIG.19

START

S710 — START DETECTION IN SELF-CAPACITANCE DETECTION MODE

S720 — DOES OBJECT TO BE DETECTED COME CLOSE? — NO

YES

S730 — START DETECTION IN MUTUAL-CAPACITANCE DETECTION MODE

S740 — IS MOVEMENT OF OBJECT TO BE DETECTED ABLE TO BE DETECTED? — NO

YES

S750 — DETECT MOVEMENT OF OBJECT TO BE DETECTED

END

## FIG.20

800

110 SENSOR ELEMENT UNIT

140 SENSOR CIRCUIT UNIT

170 SWITCHING UNIT

144    150

120

| TRANSMITTING ELECTRODE | | TRANSMITTING CIRCUIT |

| RECEIVING ELECTRODE | | RECEIVING CIRCUIT |

130          172    174  142    160

## FIG.21

800

140 SENSOR CIRCUIT UNIT

170 SWITCHING UNIT

144    150

120

240

200

| OBJECT TO BE DETECTED | TRANSMITTING ELECTRODE | | TRANSMITTING CIRCUIT |

220

| RECEIVING ELECTRODE | | RECEIVING CIRCUIT |

240

130          172    174  142    160

## FIG.22

Europäisches
Patentamt

European
Patent Office

Office européen
des brevets

# EUROPEAN SEARCH REPORT

Application Number

EP 14 17 9265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/292945 A1 (REYNOLDS JOSEPH KURTH [US] ET AL) 18 November 2010 (2010-11-18) * paragraph [0175] - paragraph [0184]; figures 17A, 17B, 18A, 18B, 19A, 19B, 20A, 20B * * paragraph [0114] - paragraph [0116] * * figure 23 * | 1-11 | INV. H03K17/955 H03K17/96 G06F3/044 |
| X | WO 2011/137200 A1 (MICROCHIP TECH INC [US]; HANAUER JERRY [US]; O'CONNOR TODD [US]) 3 November 2011 (2011-11-03) | 1,2,4-6, 10,11 | |
| A | * abstract; figure 18 * * page 22, line 24 - page 23, line 23; figures 9,10 * * page 27, line 24 - page 32, line 6; figures 12,13 * | 3 | |

TECHNICAL FIELDS SEARCHED (IPC)

H03K
G06F

The present search report has been drawn up for all claims

| Place of search | Date of completion of the search | Examiner |
|---|---|---|
| The Hague | 5 December 2014 | Fermentel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 14 17 9265

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2014

| Patent document cited in search report | | | Publication date | Patent family member(s) | | | Publication date |
|---|---|---|---|---|---|---|---|
| US 2010292945 | A1 | | 18-11-2010 | CN | 102439851 | A | 02-05-2012 |
| | | | | CN | 103925935 | A | 16-07-2014 |
| | | | | EP | 2430757 | A2 | 21-03-2012 |
| | | | | JP | 2012527052 | A | 01-11-2012 |
| | | | | KR | 20120034654 | A | 12-04-2012 |
| | | | | US | 2010292945 | A1 | 18-11-2010 |
| | | | | US | 2014132287 | A1 | 15-05-2014 |
| | | | | WO | 2010132607 | A2 | 18-11-2010 |
| WO 2011137200 | A1 | | 03-11-2011 | CN | 102782626 | A | 14-11-2012 |
| | | | | EP | 2564296 | A1 | 06-03-2013 |
| | | | | KR | 20130075721 | A | 05-07-2013 |
| | | | | TW | 201203069 | A | 16-01-2012 |
| | | | | US | 2012113047 | A1 | 10-05-2012 |
| | | | | WO | 2011137200 | A1 | 03-11-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7029467 A
- JP 2012203901 A